**Europäisches Patentamt**

**European Patent Office**

**Office européen des brevets**

(19)

(11) Veröffentlichungsnummer: **0 200 893**
**A1**

## (12) EUROPÄISCHE PATENTANMELDUNG

(21) Anmeldenummer: **86103568.1**

(22) Anmeldetag: **17.03.86**

(51) Int. Cl.⁴: **H01J 37/28**

(30) Priorität: **22.03.85 DE 3510484**

(43) Veröffentlichungstag der Anmeldung:
**17.12.86 Patentblatt 86/46**

(84) Benannte Vertragsstaaten:
**DE FR GB IT NL**

(71) Anmelder: **Siemens Aktiengesellschaft Berlin und München**
**Wittelsbacherplatz 2**
**D-8000 München 2(DE)**

(72) Erfinder: **Brust, Hans-Detlef**
**Martin-Luther-Strasse 2**
**D-6602 Dudweiler(DE)**

(54) **Verfahren zur Hervorhebung eines Objektbereichs auf einer vom Primärstrahl eines Rastermikroskops abgetasteten Probenfläche und Anordnungen zur Durchführung desselben.**

(57) Zur Hervorhebung eines Objecktbereichs auf einer von dem Primärstrahl eines Rastermikroskops zeilenweise abgetasteten Probenfläche werden die Ablenkspannungen des Rastergenerators in ihnen zugeordneten Diskriminatoren (12, 13) mit einstellbaren Vergleichsspannungen verglichen, wobei als Vergleichsergebnis ein Steuersignal (UST) gebildet wird, das angibt, ob der jeweils abgetastete Punkt der Probenfläche im Objektbereich liegt. Das Steuersignal dient zur Veränderung der Rastergeschwindigkeit und/oder der Bandbreite einer Auswerteschaltung (4) und/oder der Intensität des Primärstrahls.

FIG 1

## Verfahren zur Hervorhebung eines Objektbereichs auf einer vom Primärstrahl eines Rastermikroskops abgetasteten Probenfläche und Anordnungen zur Durchführung desselben

Die Erfindung bezieht sich auf ein Verfahren zur Hervorhebung eines Objektbereichs auf einer vom Primärstrahl eines Rastermikroskops abgetasteten Probenfläche nach den Oberbegriffen der Patentansprüche 1 und 2, sowie auf Anordnungen zur Durchführung des Verfahrens.

Bei der zeilenweisen Abtastung einer Probenfläche durch ein Rastermikroskop mußte bisher die Rastergeschwindigkeit während des ganzen Abtastvorgangs auf einen für einen interessierenden Objektbereich maximal zulässigen Wert beschränkt werden, auch wenn das zu langen Bildaufnahmezeiten führte. Eine Erhöhung der Rastergeschwindigkeit über diesen zulässigen Wert hinaus, die außerhalb des interessierenden Objektbereichs ohne Nachteile hätte angewendet werden können, wäre gleichzeitig Ursache für eine Verringerung der Ortsauflösung der Empfindlichkeit bei der Darstellung des eigentlich interessierenden Objektbereichs gewesen.

Der Erfindung liegt daher die Aufgabe zugrunde, ein Verfahren der eingangs genannten Art anzugeben, das sowohl eine kurze Bildaufnahmezeit als auch eine genaue Darstellung eines interessierenden Objektbereichs auf der Probenfläche ermöglicht. Das wird erfindungsgemäß durch eine Ausbildung des Verfahrens nach dem kennzeichnenden Teil des Anspruchs 1 erreicht. Gemäß weiterer Erfindung wird diese Aufgabe auch durch eine Ausbildung des Verfahrens nach dem kennzeichnenden Teil des Anspruchs 2 gelöst.

Der mit der Erfindung erzielbare Vorteil liegt insbesondere in einer höheren Ortsauflösung und Empfindlichkeit bei der Darstellung des interessierenden Objektbereichs unter gleichzeitiger Reduzierung der Bildaufnahmezeit.

Der Anspruch 3 ist auf eine bevorzugte Ausgestaltung des Verfahrens nach den Ansprüchen 1 und 2 gerichtet, während die Ansprüche 4 bis 11 vorteilhafte Anordnungen zur Durchführung des Verfahrens betreffen.

Die Erfindung wird nachfolgend anhand der Zeichnung näher erläutert. Dabei zeigen:

Fig. 1 eine erste Anordnung zur Durchführung des erfindungsgemäßen Verfahrens und

Fig. 2 eine alternativ ausgebildete Teilschaltung von Fig. 1.

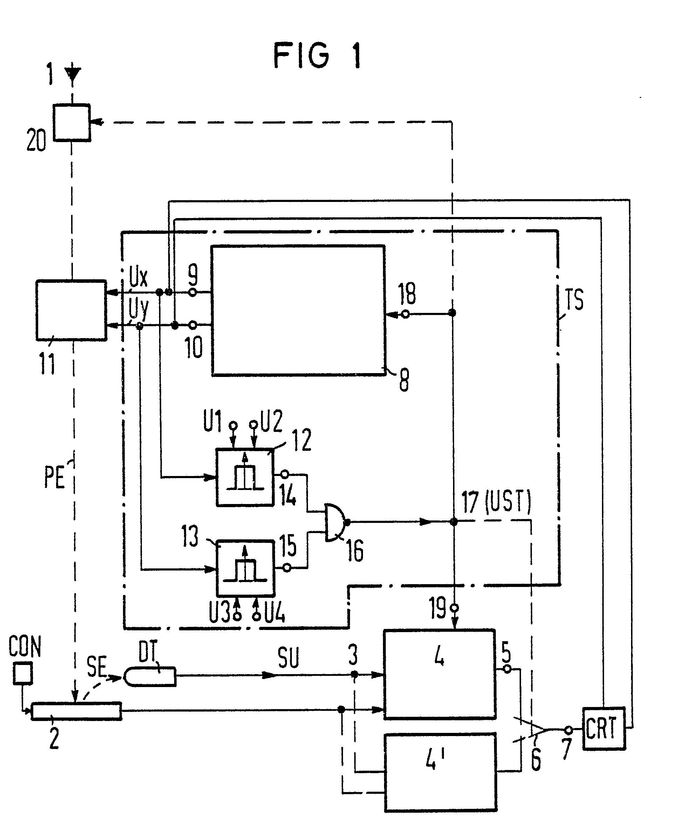

Bei der Anordnung nach Fig. 1 bilden die aus einer Elektronenquelle 1 eines Rasterelektronenmikroskops austretenden Elektronen eine Primärstrahl PE. Dieser trifft auf eine Probe 2, z.B. einen zu untersuchenden integrierten Schaltkreis, und löst dort Sekundärelektronen SE aus. Diese werden in einem Detektor DT nachgewiesen, der z.B. über einen nicht eigens dargestellten Fotomultiplier ein entsprechendes sekundäres elektrisches Signal SU abgibt. SU wird dem Eingang 3 einer bandbreitenbegrenzten Auswerteschaltung 4 zugeführt, in der Signalanteile von SU selektiert und demoduliert oder gleichgerichtet werden können, so daß am Ausgang 5 der Auswerteschaltung 4 ein Ausgangssignal zur Verfügung steht. Dieses wird in der gezeichneten Lage eines Umschalters 6 dem Intensitätssteuereingang 7 einer Bildröhre CRT zugeführt. Die x-und y-Ablenkeinrichungen von CRT werden von einem Rastergenerator 8 über seine Ausgänge 9 und 10 angesteuert. Die am Ausgang 9 auftretende x-Ablenkspannung $U_x$ und die am Ausgang 10 auftretende y-Ablenkspannung $U_y$ werden außerdem entsprechenden Eingängen einer Ablenkeinheit 11 zugeführt, die eine rasterförmige Ablenkung des Primärstrahls PE veranlaßt. Damit wird eine synchrone Ablenkung des Primärstrahls PE über die Fläche der Probe 1 und des Elektronenstrahls von CRT über den Bildschirm dieser Bildröhre erreicht. Der jeweils abgetastete Punkt auf der Probe 2 kann z.B. ein über eine Ansteuerung CON zugeführtes Eingangssignal oder ein auf der Probe selbst erzeugtes Signal einer bestimmten Signalfrequenz fs führen. Dieses Signal beeinflußt die Menge der jeweils austretenden Sekundärelektronen SE, so daß auch das Meßsignal SU einen Signalanteil der Frequenz fs aufweist. Durch eine Abstimmung der Auswerteschaltung 4 auf fs wird dieser Signalanteil selektiert und demoduliert, so daß das bei 5 auftretende Ausgangssignal das Vorhandensein eines Signals der Signalfrequenz fs an dem jeweils abgetasteten Punkt der Probe 2 angibt. Durch die Abrasterung der Probenfläche, die in nebeneinanderliegenden Zeilen erfolgt, gelingt es, auf dem Bildschirm von CRT diejenigen Teile der Probenfläche durch Helltastung des Elektronenstrahls darzustellen, die die Signalfrequenz fs führen.

Die Ablenkspannung $U_x$ wird nun einem Diskriminator zugeführt, der aus einem mit zwei Vergleichsspannungen U1 und U2 beaufschlagten Komparator 12 besteht. In analoger Weise wird $U_y$ einem zweiten Diskriminator zugeführt, der aus einem mit zwei Vergleichsspannungen U3 und U4 beaufschlagten Komparator 13 gebildet ist. Der Komparator 12 gibt über den Ausgang 14 ein Ausgangssignal ab, wenn Ux in dem Intervall zwischen den beiden Spannungen U1 und U2 liegt, der Komparator 13 über den Ausgang 15 ein Ausgangssignal, wenn Uy zwischen U3 und U4 liegt. Die Ausgänge 14 und 15 sind mit den Eingängen eines NAND-Gatters 16 verbunden, an dessen Ausgang 17 ein Steuersignal UST auftritt, das angibt, ob Ux und Uy jeweils in den durch die Vergleichsspannungen definierten Spannungsintervallen liegen. Entsprechen die einstellbaren Vergleichsspannungen U1 bis U4 jeweils den Grenzen eines auf der Probenfläche interessierenden Objektbereichs, so gibt das Steuersignal UST an, ob der jeweils abgetastete Punkt innerhalb dieses Objektbereichs liegt. Das Steuersignal UST kann daher einen Steuereingang 18 des Rastergenerators 8 zur Umschaltung der Rastergeschwindigkeit zugeführt werden. Wird die Probe außerhalb des interessierenden Objektbereichs mit einer wesentlich höheren Rastergeschwindigkeit abgerastet, die nur innerhalb dieses Objektbereichs, d.h. beim Nichtauftreten von UST, verringert wird, so kann die Bildaufnahmezeit ganz erheblich reduziert werden, ohne daß die maximal zulässige Abtastgeschwindigkeit für die genaue Auswertung an den interessierenden Stellen der Probe überschritten werden muß.

Um eine genaue Auswertung der innerhalb des interessierenden Objektbereichs abgeleiteten Meßsignale SU in der Auswerteschaltung zu ermöglichen, ist es zweckmäßig, daß Steuersignal UST einem Steuereingang 19 von 4 zuzuführen, über den eine Umschaltung von einem außerhalb des interessierenden Objektbereichs verwendeten, breitbandigen Betriebsmodus in einen - schmalbandigen Betriebsmodus vorgenommen wird. Eine andere Möglichkeit einer solchen Umschaltung besteht darin, eine zweite Auswerteschaltung 4' vorzusehen, die wesentlich - schmalbandiger ausgebildet ist als 4 und zu dieser eingangsseitig parallel geschaltet ist und den Umschalter 6 mittels des Signals UST in seine gestrichelte Lage umzuschalten, in der er das Ausgangssignal von 4' an den Eingang 7 von CRT durchschaltet. Die Umschaltung der Bandbreite von 4 kann auch zugleich mit der Umschaltung des Rastergenerators 8 auf eine niedrigere Rastergeschwindigkeit erfolgen.

Das Steuersignal UST kann zur Intensitätssteuerung des Primärelektronenstrahls PE herangezogen werden. Das empfiehlt sich insbesondere dann, wenn einzelne Teilbereiche der Probe besonders empfindlich auf Elektronenbestrahlung reagieren. Es kann sich z.B. um Stellen handeln, die sich besonders leicht aufladen. Man kann nun einen Intensitätsmodulator 20 mit UST so ansteuern, daß er in einem eingestellten Objektbereich die Intensität von PE verringert und insbesondere den Primärstrahl ganz austastet. Unter dem Intensitätsmodulator 20 wird im Sinne der Erfindung z.B. ein Strahlaustastsystem oder der Weneltzylinder der im Rasterelektronenmikroskop vorgesehenen Elektronenkanone verstanden. Die Intensitätssteuerung von PE kann mit Vorteil auch mit der Rastergeschwindigkeitssteuerung gekoppelt sein. Auf diese Weise läßt sich etwa eine konstante Energiedosis über der gesamten abgerasterten Probenfläche erzielen.

Nach einer Weiterbildung der Erfindung kann der Schaltungspunkt 5 auch mit einem zusätzlichen Signal, insbesondere einem Topographiesignal, belegt sein, das in an sich bekannter Weise z.B aus dem sekundären elektrischen Signal SU gewonnen wird. Hierzu wird auf das Buch von L. Reimer und G. Pfefferkorn "Raster-Elektronenmikroskopie" Springer-Verlag, Berlin 1977, vgl. Seiten 1-3 und 109-130 verwiesen.

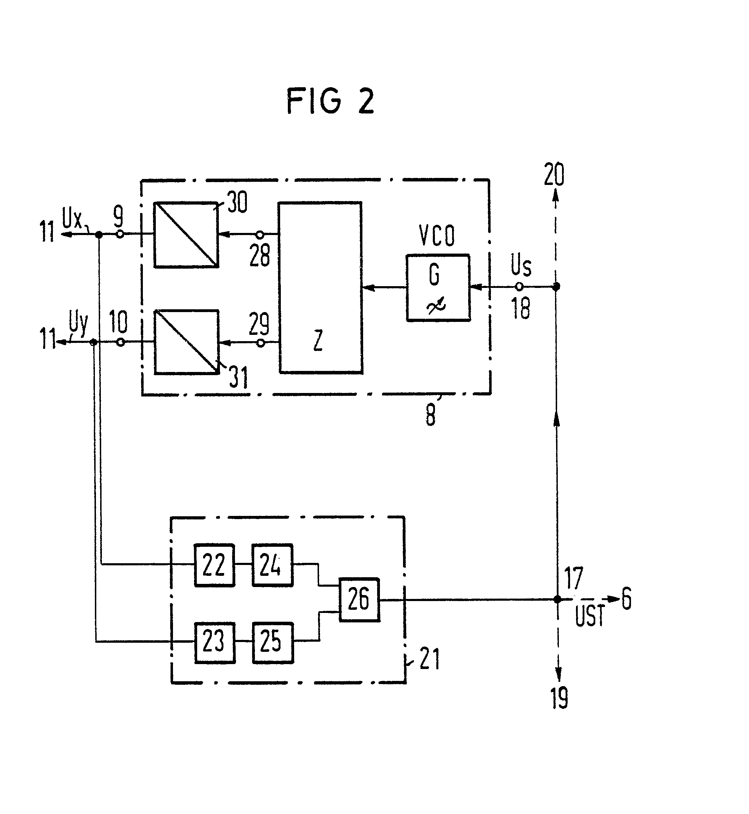

Die in Fig. 1 mit TS bezeichnete Teilschaltung kann auch durch eine Schaltung nach Fig. 2 ersetzt sein. Hierbei ist ein Funktionsnetzwerk 21 vorgesehen, daß aus den Ablenkspannungen Ux, Uy das Steuersignal UST ableitet. In einem bevorzugten Ausführungsbeispiel besteht 21 aus zwei Qudrierern 22, 23, diesen nachgeschalteten, gegebenenfalls in ihrer Verstärkung einstellbaren Verstärkerstufen 24, 25 und einem Addierer 26, der mit den Ausgängen der Verstärkerstufen 24, 25 beschaltet ist. Der Ausgang des Addierers 26 ist dabei mit dem Schaltungspunkt 17 verbunden. Mit einem Funtkionsnetzwerk 21 dieser Art läßt sich die Funktion $UST = A \times Ux^2 + B \times Uy^2$ realisieren, wenn mit A die Verstärkung der Stufe 24 und mit B die Verstärkung der Stufe 25 gekennzeichnet ist. Geht man davon aus, daß der Spannungsnullpunkt für Ux und Uy jeweils in der mit PE abzutastenden Probenfläche liegt, so ergibt sich ein relativ kleines Steuersignal UST für den mittleren Bereich der Probenfläche, während den Randbereichen derselben jeweils größere Werte zugeordnet sind. Durch eine entsprechende Einstellung der Verstärkung der Stufen 24 bzw. 25 lassen sich die Abmessungen des mittleren Bereichs in x-Ablenkrichtung bzw. y-Ablenkrichtung verändern. Einen ähnlichen Effekt erzielt man, falls man die Funktion $UST = (A \times Ux + B \times Uy)^2$ realisiert. Dazu kann man die beiden Ablenkspannungen Ux und Uy über Verstärker, gegebenenfalls mit einstellbarer Verstärkung A und B, einem Addierer zuführen und dessen Ausgangssignal quadrieren. Das Ausgangssignal des Quadrierers läßt sich dann als Steuersignal UST benutzen.

Neben den vorstehend beschriebenen Funktionen lassen sich auch andere Funktionen, die z.B. durch einen abschnittsweise stetigen Kurvenverlauf gekennzeichnet sind, realisieren.

Die Steuerspannung UST wird auch nach Fig. 2 zur Veränderung der Rastergeschwindigkeit und/oder zur Veränderung der Bandbreite der Auswerteschaltung und/oder zur Intensitätssteuerung des Primärstrahls PE verwendet.

In Fig. 2 ist auch eine zweckmäßige - schaltungstechnische Durchbildung des Rastergenerators 8 gezeigt. Diese besteht aus einem Taktoszillator G, der durch das bei 18 anliegende Steuersignal UST in seiner Taktfrequenz beeinflußt wird. Man kann G als VCO (Voltage Controlled Oscillator) bezeichnen. Eine nachgeschaltete Zählschaltung Z zählt die von G abgegebenen Taktimpulse, wobei am Ausgang 28 ein von einem ersten Zähler ausgegebenes Ergebnis erscheint, während am Ausgang 29 ein von einem zweiten Zähler ausgegebenes Zählergebnis erhalten wird, das sich von dem ersten durch eine Teilung um einen der Anzahl der abzutastenden Punkte pro Zeile entsprechenden Faktor unterscheidet. Die Ausgänge 28 und 29 sind mit DigitalAnalog-Wandlern 30, 31 verbunden, deren Ausgänge den Ausgängen 9 und 10 des Rastergenerators 8 entsprechen. Der periodische Verlauf der Ablenkspannung Ux und Uy wird durch periodisches Rücksetzen des ersten und zweiten Zählers erreicht.

Im Rahmen der Erfindung kann das Steuersignal UST auch eine Vergrößerung der Rastergeschwindigkeit und/oder eine Vergrößerung der Bandbreite der Auswerteschaltung bewirken. In diesem Fall wird z.B. der außerhalb des durch die Spannungsintervalle bestimmten Bereichs der Probenfläche liegende Bereich genauer ausgewertet. Andererseits kann das Steuersignal UST auch eine Vergrößerung der Intensität des Primärstrahls des Rastermikroskops herbeiführen.

An die Stelle der Bildröhre CRT kann selbstverständlich auch jede andere Aufzeichnungs-bzw. Darstellungseinrichtung (z.B. Plasmabildschirm, LCD-Anzeige) treten.

Obgleich sich das zuvor beschriebene Ausführungsbeispiel auf ein Rasterelektronenmikroskop bezieht, können statt dieses Mikroskops auch andere Rastermikroskope, z.B. ein Laser-Rastermikroskop oder ein Ultraschall-Rastermikroskop, verwendet werden.

**Ansprüche**

1. Verfahren zur Hervorhebung eines Objektbereichs auf einer von dem Primärstrahl eines Rastermikroskops zeilenweise abgetasteten Probenfläche, bei dem ein Rastergenerator zur Erzeugung von Ablenkspannungen herangezogen wird, die einer den Primärstrahl beeinflussenden Ablenkeinrichtung zugeführt werden und bei dem von dem jeweils abgetasten Punkt der Probe ein sekundäres elektrisches Signal; insbesondere über einen Detektor, abgeleitet und einer Auswerteschaltung zugeführt wird, der eine durch die Ablenkspannungen des Rastergenerators angesteuerte Aufzeichnungseinrichtung, insbesondere Bildröhre, nachgeschaltet ist, **dadurch gekennzeichnet,** daß wenigstens eine der Ablenkspannungen des Rastergenerators einem Diskriminator zugeführt wird, der diese mit einstellbaren Bereichsgrenzen vergleicht und mittels eines Steuersignals die Einhaltung dieser Bereichsgrenzen angibt und daß das Steuersignal zur Veränderung der Rastergeschwindigkeit und/oder zur Veränderung der Bandbreite der Auswerteschaltung und/ oder zur Veränderung der Intensität des Primärstrahls verwendet wird.

2. Verfahren zur Hervorhebung eines Objektbereichs auf einer vom Primärstrahl eines Rastermikroskops in nebeneinanderliegenden Zeilen abgetasteten Probenfläche, bei dem ein Rastergenerator zur Erzeugung von Ablenkspannungen herangezogen wird, die einer den Primärstrahl beeinflussenden Ablenkeinheit zugeführt werden und bei dem von dem jeweils abgetasteten Punkt der Probe ein sekundäres elektrisches Signal, insbesondere über einen Detektor, abgeleitet und einer Auswerteschaltung zugeführt wird, der ein durch die Ablenkspannungen des Rastergenerators angesteuerte Aufzeichnungseinrichtung, insbesondere Bildröhre, nachgeschaltet ist, **dadurch gekennzeichnet,** daß beide Ablenkspannungen des Rastergenerators einem Funktionsnetzwerk zugeführt werden, das ein von beiden Ablenkspannungen nach einer vorgegebenen Funktion abhängiges Steuersignal liefert und daß das Steuersignal zur Veränderung der Rastergeschwindigkeit und/oder zur Veränderung der Bandbreite der Auswerteschaltung und/oder zur Veränderung der Intensität des Primärstrahls herangezogen wird.

3. Verfahren nach Anspruch 1 oder 2, **dadurch gekennzeichnet,** daß in Abhängigkeit vom Steuersignal ein zusätzliches Signal, insbesondere ein Topographiesignal oder ein bei schneller Rastergeschwindigkeit gewonnenes Übersichtssignal anstelle des für die Auswertung des Objektbereichs vorgesehenen, am Ausgang der Auswerteschaltung gewonnenen Signals der Aufzeichnungseinrichtung zugeführt wird.

4. Anordnung zur Durchführung des Verfahrens nach einem der Ansprüche 1 oder 3, **dadurch gekennzeichnet**, daß der Diskriminator einen oder zwei gleichartig ausgebildete Komparatoren enthält, die jeweils mit Vergleichsspannungen beaufschlagt sind, und daß bei Zuführung einer oder zweier Ablenkspannungen des Rastergenerators ein Steuersignal abgegeben wird, das angibt, ob die Ablenkspannung(en) in dem (den) Spannungsintervall(en) zwischen den Vergleichsspannungen liegen.

5. Anordnung zur Durchführung des Verfahrens nach Anspruch 2 oder 3, **dadurch gekennzeichnet**, daß das Funktionsnetzwerk das Steuersignal von den Amplituden wenigstens einer Ablenkspannung des Rastergenerators nach einer vorgegebenen Funktion ableitet.

6. Anordnung nach Anspruch 5, **dadurch gekennzeichnet**, daß das Funktionsnetzwerk aus zwei mit den Ablenkspannungen des Rastergenerators beaufschlagten Quadrierern, diesen zugeordneten, in ihren jeweiligen Verstärkungen einstellbaren Verstärkerstufen und einem nachgeschalteten Addierer besteht.

7. Anordnung nach einem der Ansprüche 4 bis 6, **dadurch gekennzeichnet**, daß das Funktionsnetzwerk aus zwei mit den Ablenkspannungen des Rastergenerators (8) beaufschlagten, in ihren jeweiligen Verstärkungen einstellbaren Verstärkerstufen, einem nachgeschalteten Addierer und einem Quadrierer besteht.

8. Anordnung nach einem der Ansprüche 4 bis 7, **dadurch gekennzeichnet**, daß zur Veränderung der Intensität des Primärstrahls ein Intensitätsmodulator (20) dient, der mit dem Steuersignal (UST) beaufschlagt ist.

9. Anordnung nach einem der Ansprüche 4 bis 8, **dadurch gekennzeichnet**, daß die Auswerteschaltung in ihrer Bandbreite veränderbar ausgebildet ist.

10. Anordnung nach einem der Ansprüche 4 bis 8, **dadurch gekennzeichnet**, daß die Auswerteschaltung schmalbandig ausgebildet ist, daß eine weitere, in gleicher Weise, jedoch breitbandig ausgebildete Auswerteschaltung vorgesehen ist und daß die Ausgänge beider Auswerteschaltungen über einen mittels des Steuersignals betätigbaren Umschalter mit der Aufzeichnungseinrichtung verbindbar sind.

11. Anordnung nach einem der Ansprüche 4 bis 10, **dadurch gekennzeichnet**, daß die Aufzeichnungseinrichtung über einen durch das Steuersignal betätigbaren Umschalter mit einem zusätzlichen Signal, insbesondere einem Topographiesignal, beschaltet ist.

FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-3 614 311 (FUJIYASU et al.) * Spalte 2, Zeile 72 - Spalte 3, Zeile 64; Spalte 4, Zeile 53 - Spalte 6, Zeile 38; Figuren 2-7 * | 1 | H 01 J 37/28 |
| Y | | 1-5,11 | |
| | --- | | |
| Y | US-A-3 711 711 (DAO et al.) * Spalte 2, Zeile 63 - Spalte 4, Zeile 49; Figur * | 1,2 | |
| | --- | | |
| A | IBM TECHNICAL DISCLOSURE BULLETIN, Band 19, Nr. 3, August 1976, Seiten 1007-1008, IBM Corp., Armonk, N.Y., US; J.J. DESTAFENO et al.: "Scanning electron microscope system for testing circuit devices" * Insgesamt * | | |
| | ----- | | |

RECHERCHIERTE SACHGEBIETE (Int. Cl.4)

H 01 J 37
H 04 N 3
G 02 B 21

Der vorliegende Recherchenbericht wurde für alle Patentansprüche erstellt.

| Recherchenort DEN HAAG | Abschlußdatum der Recherche 25-06-1986 | Prüfer SCHAUB G.G. |
|---|---|---|